Europäisches Patentamt

(19) European Patent Office

Office européen des brevets

(11) Veröffentlichungsnummer: **0 001 756**
**B1**

# (12) EUROPÄISCHE PATENTSCHRIFT

(45) Veröffentlichungstag der Patentschrift:
**30.12.81**

(21) Anmeldenummer: **78101053.3**

(22) Anmeldetag: **02.10.78**

(51) Int. Cl.³: **H 02 M 1/06,** H 01 L 29/743,
H 03 K 17/72

(54) Schaltungsanordnung zum Herabsetzen der Freiwerdezeit eines Thyristors.

(30) Priorität: **27.10.77 DE 2748316**

(43) Veröffentlichungstag der Anmeldung:
**16.05.79 Patentblatt 79/10**

(45) Bekanntmachung des Hinweises auf die Patenterteilung:
**30.12.81 Patentblatt 81/52**

(84) Benannte Vertragsstaaten:
**CH FR GB SE**

(56) Entgegenhaltungen:
**DE-A-2 607 678**
**DE-B-2 431 022**
**DE-B-1 638 378**

(73) Patentinhaber: **SIEMENS AKTIENGESELLSCHAFT Berlin
und München, Postfach 22 02 61, D-8000 München 22 (DE)**

(72) Erfinder: **Lehmann, Erhard, Römerstrasse 58,
D-8011 Aschheim (DE)**
Erfinder: **Wojtalla, Peter, Ringhofferstrasse 126,
D-8044 Lohhof (DE)**
Erfinder: **Voss, Peter, Freischützstrasse 17,
D-8000 München 81 (DE)**

## Schaltungsanordnung zum Herabsetzen der Freiwerdezeit eines Thyristors

Die vorliegende Erfindung bezieht sich auf eine Schaltungsanordnung zum Herabsetzen der Freiwerdezeit eines Thyristors, der eine Steuerelektrode, eine Hauptemitterelektrode und mindestens eine zwischen Hauptemitterelektrode und Steuerelektrode liegende Hilfsemitterelektrode aufweist, mit einer ersten Stromquelle, die zwischen Steuerelektrode und Hilfsemitterelektrode liegt und die Impulse der einen Polarität in die Steuerelektrode einspeist, und mit einer zweiten Stromquelle, die Impulse der anderen Polarität in den Kreis Hauptemitter-Hilfsemitter einspeist.

Unter der Freiwerdezeit eines Thyristors versteht man die zwischen Nulldurchgang des Laststroms und Wiedererlangung der Blockierfähigkeit des Thyristors liegende Zeit. Eine Schaltungsanordnung zum Herabsetzen der Freiwerdezeit eines Thyristors der obengenannten Art ist zum Beispiel aus der DE-A-26 07 678 bekannt. Eine Ausführungsart dieser Schaltungsanordnung besteht aus einem Kondensator, dessen einer Anschluss mit der Hauptemitterelektrode und dessen anderer Anschluss über die Parallelschaltung eines Widerstandes mit einer Diode mit der Hilfsemitterelektrode verbunden ist. Der Kondensator wird durch den Rückstrom des Thyristors aufgeladen. Dieser Rückstrom entsteht dadurch, dass im Halbleiterkörper gespeicherte Ladungsträger bei Umkehr der Thyristorspannung in umgekehrter Richtung fliessen. Der Entladestrom des Kondensators bewirkt ein Absaugen dieser gespeicherten Ladungsträger, wodurch die Freiwerdezeit des Thyristors herabgesetzt wird. Der Entladestrom wird bestimmt durch die Entladewiderstände und die Kondensatorspannung, welche wiederum vom Rückstrom und damit letztlich von den Betriebsparametern des Thyristors abhängig ist.

Der Erfindung liegt die Aufgabe zugrunde, eine Schaltungsanordnung der oben erwähnten Gattung so weiterzubilden, dass die Freiwerdezeit von den Parametern des Thyristors entkoppelt ist.

Diese Aufgabe wird durch die Erfindung dadurch gelöst, dass die zweite Stromquelle eine selbständige Stromquelle ist, die vom Thyristor unabhängige Impulse liefert.

Aus der DE-B-24 31 022 (man vergleiche Fig. 1 der vorliegenden Anmeldung) ist zwar bereits eine Schaltungsanordnung zum Herabsetzen der Freiwerdezeit eines Thyristors bekannt, bei der die Abschalthilfeimpulse unabhängig von den Thyristorparametern eingespeist werden können. Die einzige Stromquelle liefert Zündimpulse und Abschalthilfeimpulse, wobei eine Ausgangsklemme mit der Hauptemitterelektrode und die andere Ausgangsklemme mit der Steuerelektrode und über eine für negative Impulse durchlässige Diode mit der Hilfsemitterelektrode verbunden ist. Diese Schaltung hat jedoch den Nachteil, dass am Ende der Abschalthilfeimpulse durch Überschwingen auftretende positive Spannungsspitzen wiederum zu einem unbeabsichtigten Zünden des Thyristors führen. Dieser Effekt wird durch die Erfindung in überraschender Weise ausgeschaltet.

Die Erfindung wird an Hand von Ausführungsbeispielen in Verbindung mit den Fig. 1 bis 3 näher erläutert. Es zeigen:

Fig. 1 eine Schaltungsanordnung gemäss dem Stand der Technik,

Fig. 2 eine erstes Ausführungsbeispiel gemäss der Erfindung,

Fig. 3 ein zweites Ausführungsbeispiel gemäss der Erfindung.

Gleiche und funktionsgleiche Teile sind mit gleichen Bezugszeichen versehen.

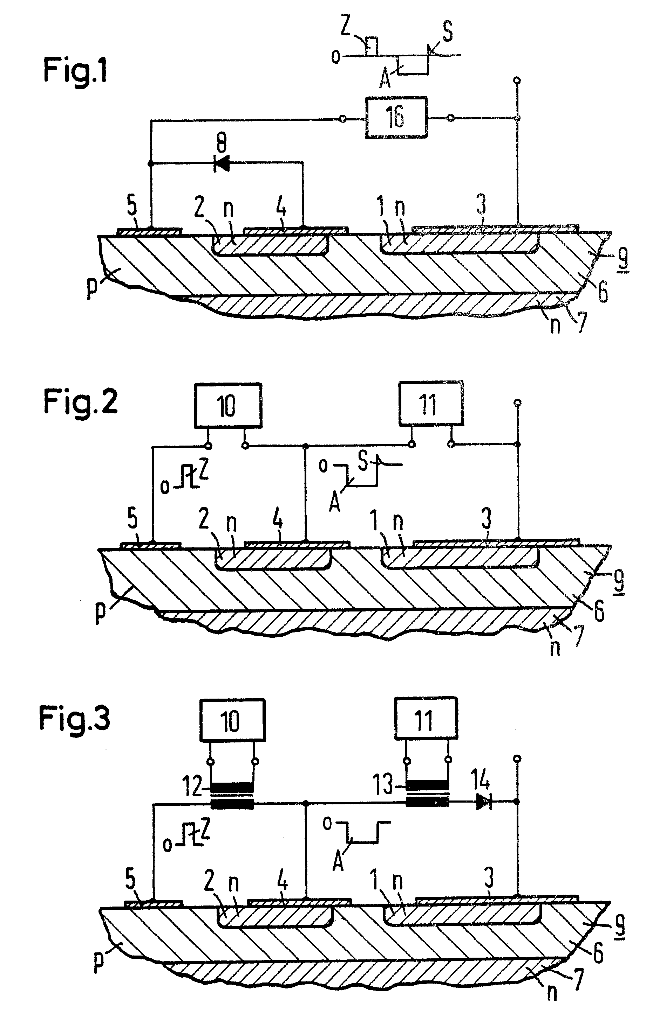

In Fig. 1 ist ein Ausschnitt aus einem Halbleiterkörper eines Thyristors dargestellt. Der Halbleiterkörper ist mit 9 bezeichnet. Der Halbleiterkörper 9 weist eine Emitterzone 1 und eine Hilfsemitterzone 2 auf, die in einer Basiszone 6 angeordnet sind. Der Emitter 1 ist mit eine Hauptemitterelektrode 3 und der Hilfsemitter 2 mit einer Hilfsemitterelektrode 4 versehen. Die Basiszone 6 ist mit einer Steuerelektrode 5 verbunden. Eine weitere Zone des Halbleiterkörpers ist mit 7 bezeichnet. Die vierte Zone des Halbleiterkörpers des Thyristors wurde der besseren Übersichtlichkeit halber weggelassen. Die Hilfsemitterelektrode 4 und die Steuerelektrode 5 sind durch eine Diode 8 verbunden. Zwischen der Hauptemitterelektrode 3 und der Steuerelektrode 5 liegt eine Stromquelle 16, die abwechselnd Impulse in positiver und negativer Polarität liefert. Diese Impulse sind in Fig. 1 schematisch dargestellt, wobei Z den positiven Zündimpuls und A den negativen Abschalthilfeimpuls darstellt. Der negative Abschalthilfeimpuls kann bei vielen Impulsquellen an der Rückflanke positiv überschwingen, was zu einer positiven Stromspitze S führt.

Die Wirkungsweise der bekannten Schaltungsanordnung ist so, dass der Zündimpuls Z zunächst auf bekannte Weise den Hilfsthyristor über die Hilfsemitterzone 2 zündet. Der Emitterstrom des Hilfsthyristors zündet den Hauptthyristor, zu dem die Emitterzone 1 gehört. Der Thyristor führt dann einen bestimmten Strom, der im wesentlichen durch die Last bestimmt ist. Am Thyristor liegt dann lediglich die geringe Durchlassspannung an. Kommutiert der durch den Thyristor fliessende Strom durch Null, so wird auch die am Thyristor liegende Spannung zu Null. Darauf beginnt im Thyristor ein negativer Strom, der sogenannte Rückstrom, zu fliessen, der ein Sperren des Thyristors zunächst verhindert. Der Abschalthilfeimpuls A wird vor dem Ansteigen der Thyristorspannung auf positive Werte über die Diode 8 an die Hilfsemitterelektrode 4 angelegt. Dadurch werden die im Inneren des Halbleiterkörpers 9 befindlichen Ladungsträger bevorzugt über die Hilfsemitterelektrode 4 abgesaugt und die Freiwerdezeit des Thyristors wird somit verkürzt. Tritt jedoch an der Rückflanke des Abschalthilfeimpulses A die positive Stromspitze S auf, so kann der Hilfsthyristor zünden und damit die Anordnung zur Verkürzung der Freiwerdezeit unwirksam machen.

In der die Erfindung aufweisenden Schaltungsanordnung nach Fig. 2 ist zwischen die Steuerelektrode 5 und die Hilfsemitterelektrode 4 eine erste Stromquelle 10 und zwischen die Hilfsemitterelektrode 4 und die Hauptemitterelektrode 3 eine zweite Impulsquelle 11 geschaltet. Die erste Stromquelle 10 liefert die Zündimpulse, die bei den eingezeichneten Leitfähigkeitstypen der Zonen des Halbleiterkörpers positiv gegenüber der Hilfsemitterelektrode sind. Die zweite Stromquelle 11 liefert entsprechend versetzt zu den Zündimpulsen Z Abschalthilfeimpulse A, die bei den eingezeichneten Leitfähigkeitstypen negativ gegenüber der Hauptemitterelektrode sind. Die Zündung und die Abschalthilfe durch den positiven Zündimpuls Z beziehungsweise den negativen Abschalthilfeimpuls A entspricht dem in Verbindung mit Fig. 1 beschriebenen Ablauf. Der wesentliche Unterschied besteht darin, dass eine bei der Rückflanke des Impulses A auftretende Stromspitze S eine gewisse Grösse erreichen kann, ohne den Thyristor zu zünden. Dies rührt daher, dass der Hauptthyristor unempfindlicher als der Hilfsthyristor ist, das heisst, dass er zum Zünden einen höheren Strom braucht als der Hilfsthyristor. Das Verhältnis der Zündströme von Hilfsthyristor zu Hauptthyristor kann zum Beispiel bei 1:20 liegen.

In Fig. 3 ist dargestellt, dass die Stromquellen 10, 11 über Übertrager 12, 13 zwischen die Steuerelektrode 5 und die Hilfsemitterelektrode 4 beziehungsweise zwischen die Hilfsemitterelektrode 4 und die Hauptemitterelektrode 3 geschaltet sind. Die Sekundärwicklung des Übertragers 13 kann über eine Diode 14 an die erwähnten Elektroden geschaltet sein, die so gepolt ist, dass der Stromkreis gegen die positive Stromspitze S überhaupt gesperrt wird. Notwendig ist die Einschaltung der Diode 14 jedoch so lange nicht, wie die positive Stromspitze nicht zum Zünden des Hauptthyristors ausreicht. Die Diode 14 kann auch bei der Schaltungsanordnung nach Fig. 2 eingesetzt werden.

Die Erfindung wurde an Hand eines Thyristors mit einem einzigen Hilfsthyristor beschrieben. Sie kann jedoch auch bei einem Thyristor mit mehr als einem Hilfsthyristor angewendet werden. Zweckmässigerweise wird die Stromquelle 11 dann zwischen die Hauptemitterelektrode und diejenige Hilfsemitterelektrode gelegt, die der Hauptemitterelektrode am nächsten liegt.

## Ansprüche

1. Schaltungsanordnung zum Herabsetzen der Freiwerdezeit eines Thyristors, der eine Steuerelektrode (5), eine Hauptemitterelektrode (3) und mindestens eine zwischen Hauptemitterelektrode und Steuerelektrode liegende Hilfsemitterelektrode (4) aufweist, mit einer ersten Stromquelle (10), die zwischen Steuerelektrode und Hilfsemitterelektrode liegt und die Impulse der einen Polarität in die Steuerelektrode einspeist, und mit einer zweiten Stromquelle (11), die Impulse der anderen Polarität in den Kreis Hauptemitter (1) - Hilfsemitter (2) einspeist, dadurch gekennzeichnet, dass die zweite Stromquelle (11) eine selbständige Stromquelle ist, die vom Thyristor unabhängige Impulse liefert.

2. Schaltungsanordnung nach Anspruch 1, dadurch gekennzeichnet, dass die Stromquellen (10, 11) über Übertrager (12, 13) angeschaltet sind.

3. Schaltungsanordnung nach Anspruch 1 oder 2, dadurch gekennzeichnet, dass die zweite Stromquelle (11) über eine Diode (14) in den Stromkreis Hilfsemitterelektrode - Hauptemitterelektrode - zweite Stromquelle (11) geschaltet ist, und dass die Diode (14) so gepolt ist, dass der Stromkreis gegen Impulse der einen Polarität gesperrt ist.

## Claims

1. A circuit arrangement for reducing the turn-off time of a thyristor which has a control electrode (5), a main emitter electrode (3) and at least one auxiliary emitter electrode (4) arranged between the main emitter electrode and the control electrode, comprising a first current source (10) which is located between the control electrode and the auxiliary emitter electrode and feeds pulses of one polarity to the control electrode, a second control electrode (11) which feeds in pulses of the other polarity to the main emitter (1) - auxiliary emitter (2) icrcuit, characterised in that the second current source (11) is an independent current source supplying pulses which are independent of the thyristor.

2. A circuit arrangement as claimed in Claim 1, characterised in that the current sources (10, 11) are connected by way of transformers (12, 13).

3. A circuit arrangement as claimed in Claim 1 or 2, characterised in that the second current source (11) is connected through a diode (14) into the circuit comprising the auxiliary emitter electrode, the main emitter electrode and the second current source (11), and that the diode (14) is so poled that the circuit is blocked towards pulses of said one polarity.

## Revendications

1. Montage pour réduire le temps de récupération d'un thyristor comportant une électrode de commande (5), une électrode d'émetteur principal (3) et au moins une électrode d'émetteur auxiliaire (4) située entre l'électrode d'émetteur principal et l'électrode de commande, montage présentant une première source de courant (10) située entre l'électrode de commande et l'électrode d'émetteur auxiliaire et emmagasinant dans l'électrode de commande des impulsions d'une première polarité, ainsi qu'une seconde source de courant (11) qui emmagasine des impulsions de l'autre polarité dans le circuit émetteur principal (1) - émetteur auxiliaire (2), caractérisé par le fait que la seconde source de courant (11) est une source de courant indépendante fournissant des impulsions indépendantes du thyristor.

2. Montage selon la revendication 1, caractérisé par le fait que les sources de courant (10, 11) sont branchées par l'intermédiaire de transformateurs (12, 13).

3. Montage selon la revendication 1 ou 2, caractérisé par le fait que la seconde source de courant (11) est branchée, par l'intermédiaire d'une diode (14), dans le circuit de courant électrode d'émetteur auxiliaire - électrode d'émetteur principal - seconde source de courant, et que la polarité de la diode (14) est telle que le circuit de courant est bloqué contre des impulsions de ladite première polarité.

Fig.1

Fig.2

Fig.3